# EUROPEAN PATENT SPECIFICATION

(11) **EP 4 483 683 B1**
(45) Date of publication and mention of the grant of the patent: **14.01.2026**
(21) Application number: 22709428.1
(22) Date of filing: 24.02.2022
(51) Int. Cl.: H05K 5/02

(54) **A MOUNTING SYSTEM**
MONTAGESYSTEM
SYSTÈME DE MONTAGE

(43) Date of publication of application: 01.01.2025
(73) Proprietor: Telefonaktiebolaget LM Ericsson (publ), 164 83 Stockholm (SE)
(72) Inventor: YDRING, Joel, 113 25 Stockholm (SE); WASSDAHL, Jonas, 792 37 Mora (SE); AXELSSON, Andreas, 782 34 Malung (SE)
(74) Representative: Ericsson
(86) International application number: PCT/SE2022/050192
(87) International publication number: WO 2023/163621

(56) References cited:
- KR-A- 20160 071 728
- US-A1- 2020 251 177

## Description

### TECHNICAL FIELD

Embodiments herein relate to the mounting of equipment, such as telecommunication equipment in the form of a telecommunication radio unit or similar, to a structure, such as a wall, a pole, a frame, a beam, a roof, or a tower. More particularly, the embodiments include a mounting rail for mounting of a piece of equipment to a structure, a mounting bracket for use with the mounting rail, a mounting kit for mounting the mounting rail to a pole, and a mounting system including at least the mounting rail and the mounting bracket.

### BACKGROUND

The number of telecommunication equipment units that need to be installed at a telecommunication site has grown quickly over the last decades due to increased data usage. For performance reasons, there is also a trend towards migrating telecommunication radio units from cabinets, typically placed on the ground, to elevated positions closer to the antennas. With a growing number of visible units, telecommunication sites have become cluttered and overloaded.

WO2015/165628 relates to a mounting system including a mounting rail and a mounting bracket that may be used for attaching telecommunication equipment to a wall or a pole. The mounting rail provides a mounting interface for mounting several pieces of equipment, each provided with a mounting bracket, in parallel on the wall or pole. The mounting system gives operators a chance to cluster remote units when mounted near antennas.

US20200251177A1 discloses .a system which includes a wall mounting bracket having a front side and a back side as well as a main chassis having a front side panel removably connected to the front side of the wall mounting bracket, a second side panel removably connected to the front side of the wall mounting bracket, and a computing device having a first side and a second side, the first side removably attached to the first side panel and the second side removably attached to the second side panel, and the main chassis connected to the front side of the wall mounting bracket.

In view of the rapid development in the field of data communication and the consequently growing number of telecommunication units per site, there is a need to provide further improved solutions for mounting of telecommunication equipment, in particular when it comes to versatility and cost efficiency.

### SUMMARY

A primary object of embodiments herein is to provide for an in at least some aspect improved mounting of equipment, in particular telecommunication equipment, to a structure. In particular, it is an object to provide an in at least some aspect improved mounting system and parts thereof for mounting of telecommunication equipment to a structure such as a wall, a pole, a frame, a tower, or another structure. Another object is to provide a more cost efficient and versatile mounting system and parts thereof. Other objects are to provide a mounting system and parts thereof with a relatively low carbon footprint, which can be cost efficiently produced and transported, which mounting system has a relatively high strength/weight ratio, and which mounting system offers a high flexibility in terms of how equipment can be attached thereto and how it can be mounted to a structure.

According to a first aspect of embodiments herein, at least the primary object is achieved by a mounting rail according to claim 1.

The mounting rail is intended for mounting of a piece of equipment to a structure, the piece of equipment being provided with a mounting bracket. The mounting rail comprises:
- an upper end and an opposite lower end extending in a longitudinal direction of the mounting rail,
- a front side and an opposite back side, both the front side and the back side extending between said upper and lower ends,

wherein the back side comprises at least one structure mounting interface for attaching the mounting rail to the structure,
wherein the upper end comprises an upper ridge and wherein the lower end comprises a lower ridge, the upper and lower ridges extending along the mounting rail and forming a first bracket mounting interface for mounting the mounting bracket to the front side of the mounting rail in a first orientation, and
wherein the front side comprises a second bracket mounting interface for mounting the mounting bracket to the front side of the mounting rail in a second orientation perpendicular to the first orientation.

According to a second aspect of embodiments herein, at least the primary object is achieved by a mounting bracket according to claim 7.

The mounting bracket is intended for use with the mounting rail according to the first aspect for mounting a piece of equipment to a structure. The mounting bracket comprises:
- a first part having a front side configured to be attached to the piece of equipment and an opposite back side configured to face the mounting rail, the first part having an upper end comprising at least one upper hook-shaped portion configured for engaging with the upper ridge of the mounting rail, and
- a second part having a lower end comprising at least one lower hook-shaped portion configured for engaging with the lower ridge of the mounting rail,
wherein the second part is lockingly attachable to a lower end of the first part so as to clamp the mounting bracket to the mounting rail.

According to a third aspect of embodiments herein, at least the primary object is achieved by a mounting kit according to claim 13.

The mounting kit is intended for mounting the mounting rail according to the first aspect to a pole. The mounting kit comprises:
- a pole adapter configured to be attached to the mounting rail with a front side of the pole adapter facing the mounting rail and with a back side of the pole adapter facing the pole, wherein the pole adapter is formed such that it can rest stably against the pole in a first orientation and in a second orientation, the second orientation being perpendicular to the first orientation,
an attachment device for attaching the pole adapter to the pole in at least one of the first and second orientations.

According to a fourth aspect of embodiments herein, at least the primary object is achieved by a mounting system according to claim 15.

The mounting system comprises the mounting rail according to the first aspect and the mounting bracket according to the second aspect, wherein the mounting bracket is configured to be attached in the first orientation to the first bracket mounting interface of the mounting rail, and wherein the mounting bracket is configured to be attached in the second orientation to the second bracket mounting interface of the mounting rail.

By providing a mounting rail with two mounting bracket interfaces for mounting of the mounting bracket in two different orientations, a more versatile mounting system can be achieved. The disclosed mounting rail and mounting bracket enable on the one hand horizontal mounting of a plurality of telecommunication equipment units on a vertically extending pole when the first bracket mounting interface is used for mounting the mounting bracket to the mounting rail in the first orientation, and on the other hand vertical mounting along the pole, using the second bracket mounting interface for mounting the mounting bracket to the mounting rail in the second orientation.

Advantageous embodiments of the different aspects of the invention, respectively, are defined in the dependent claims.

### BRIEF DESCRIPTION OF THE DRAWINGS

Examples of embodiments herein are described in more detail with reference to attached drawings, in which:
- **Figure 1**: is a perspective view of a mounting system according to a first embodiment,
- **Figure 2**: is another perspective view of a mounting system according to another embodiment,
- **Figure 3**: is another perspective view of the mounting system shown in Fig. 1,
- **Figure 4**: is yet another perspective view of the mounting system shown in Fig. 1,
- **Figure 5**: is a perspective view of a mounting system according to a second embodiment,
- **Figure 6**: is a bottom view of the mounting system shown in Fig. 5,
- **Figure 7**: is a side view of a mounting rail according to an embodiment,
- **Figure 8**: is a sectional view of the mounting rail shown in Fig. 7,
- **Figure 9**: is an exploded view of a mounting backet according to an embodiment,
- **Figure 10**: is a sectional view of the mounting bracket shown in Fig. 9,
- **Figure 11a-c**: illustrate three different embodiments of the mounting bracket,
- **Figure 12**: is a perspective view of a mounting kit according to a first embodiment,
- **Figure 13**: is another perspective view of a mounting kit shown in Fig. 12, and
- **Figure 14**: is a schematic front view of a mounting rail according to an embodiment.

The illustrations are schematic and not necessarily drawn to scale. Like reference numbers refer to like elements throughout the description, unless expressed otherwise.

### DETAILED DESCRIPTION

The present disclosure relates to a mounting system and parts thereof for mounting of equipment, in particular telecommunication equipment, to a structure in the form of a wall, a pole, a frame, a beam, a roof, or a tower, or similar.

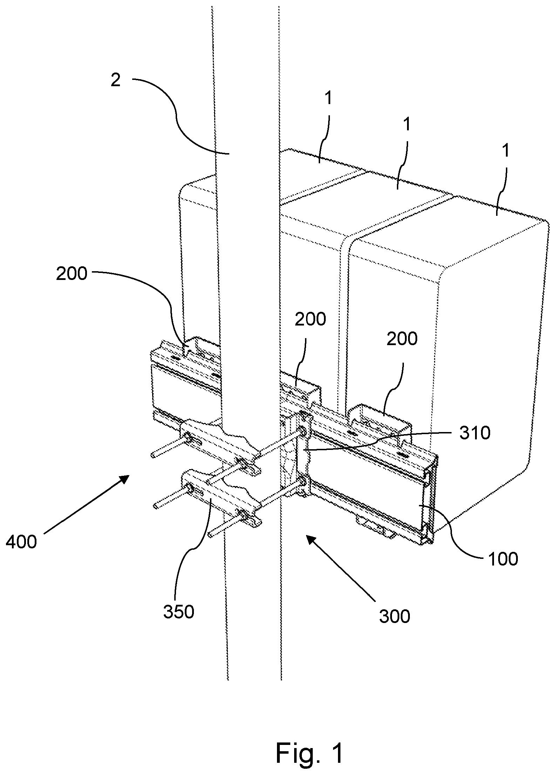

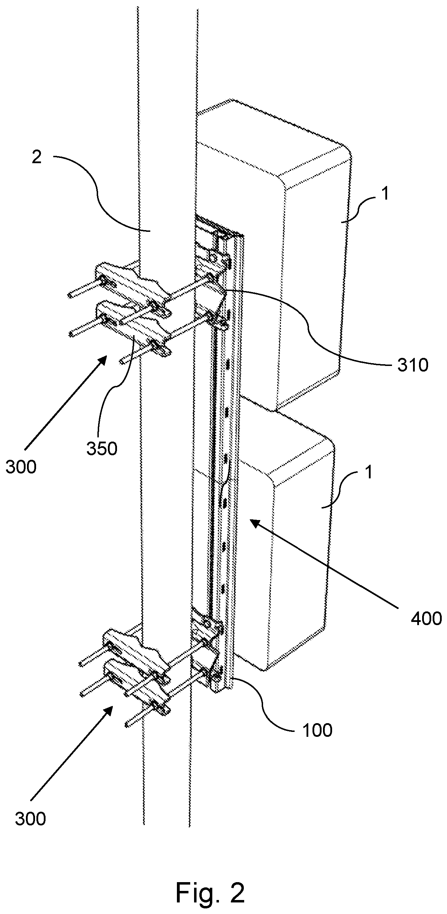

A mounting system 400 according to an example embodiment of the present disclosure is illustrated in Figs. 1 and 2. The mounting system 400 is in Fig. 1 used for mounting of a plurality of pieces of equipment 1, herein three pieces of equipment 1, to a structure 2 in the form of a pole 2, wherein the pieces of equipment 1 are aligned in a horizontal direction, perpendicular to a direction of extension of the pole 2. In Fig. 2, the mounting system 400 is used for vertical mounting of a plurality of pieces of equipment 1, herein two pieces of equipment 1, to a pole 2. The two pieces of equipment 2 are in Fig. 2 mounted above one another on the pole 2.

The mounting system 400 herein comprises a mounting rail 100, at least one mounting bracket 200 (hidden in Fig. 2), and at least one mounting kit 300. When the structure to which the equipment is to be mounted is a wall or similar, the mounting system 400 comprises the mounting rail 100 and the mounting bracket(s) 200, but it does not need to comprise the mounting kit 300. Instead, the mounting rail 100 can be attached directly to the wall, frame, or similar, using fastening devices such as screws.

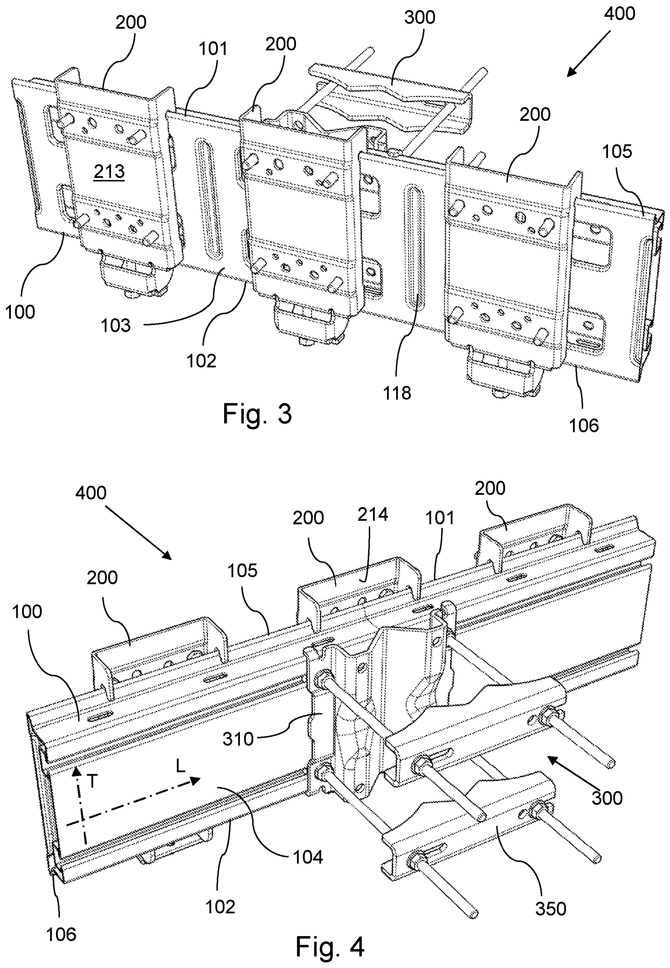

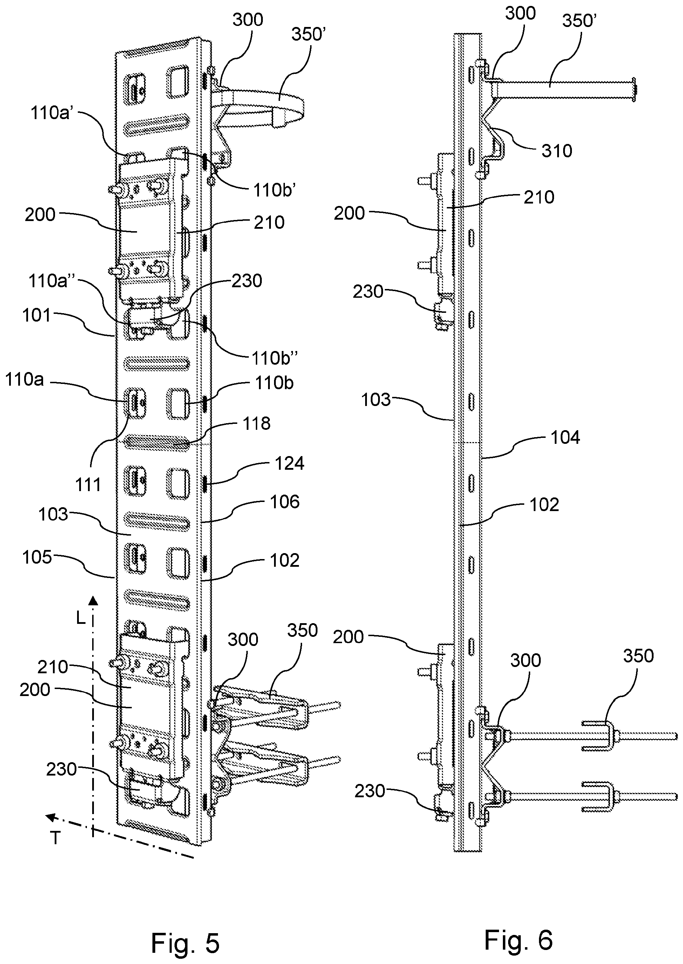

The mounting system 400 according to a first embodiment is illustrated in greater detail in Figs. 3-4, and according to a second embodiment in Fig. 5-6. The parts of the mounting system 400 according to the second embodiment only differ from the first embodiment in the length of the mounting rail 100, and in the configuration of the mounting kit 300. However, in the second embodiment, the mounting bracket 200 is attached to the mounting rail 100 in a different orientation than in the first embodiment. The mounting system 400 is in Fig. 3 illustrated in a configuration suitable for horizontal mounting of pieces of equipment 1 on a pole 2 (cf. Fig. 1), while it is Fig. 4 illustrated in a configuration suitable for vertical mounting of pieces of equipment 1 on a pole 2 (cf. Fig. 2). It is to be noted that the mounting rail 100 may have any suitable length, depending on the intended application.

The mounting rail 100 for mounting of a piece of equipment 1 provided with a mounting bracket 200 to a structure 2 comprises an upper end 101 and an opposite lower end 102. The upper and lower ends 101, 102 extend in a longitudinal direction L of the mounting rail 100. The mounting rail 100 further comprises a front side 103 and an opposite back side 104, both the front side 103 and the back side 104 extending between the upper and lower ends 101, 102. The front and back sides 103, 104 thus mechanically connect the upper and lower ends 101, 102. The back side 104 comprises at least one structure mounting interface for attaching the mounting rail 100 to the structure 2, such as to the wall or pole. The "upper end" 101 herein refers to the end shown as uppermost in Figs. 3-4. However, the mounting rail 100 may be symmetric, with identical upper and lower ends 101, 102. Furthermore, the mounting rail 100 may be mounted in a vertical orientation such as illustrated in Fig. 2, in which case the "upper end" 101 and the "lower end" 102 will also extend vertically. Thus, "upper" and "lower" is herein used merely for annotation.

The upper end 101 of the mounting rail 100 comprises an upper ridge 105 and the lower end 102 comprises a lower ridge 106. The upper and lower ridges 105, 106 extend in parallel along the mounting rail 100, i.e. in the longitudinal direction L, and form a first bracket mounting interface for mounting the mounting bracket 200 to the front side 103 of the mounting rail 100 in a first orientation, as illustrated in figs. 3-4. The front side 103 further comprises a second bracket mounting interface for mounting the mounting bracket 200 to the front side 103 of the mounting rail 100 in a second orientation perpendicular to the first orientation, i.e. rotated 90° from the first orientation in a plane defined by the front side 103 of the mounting rail 100. The second orientation is illustrated in Figs. 5-6.

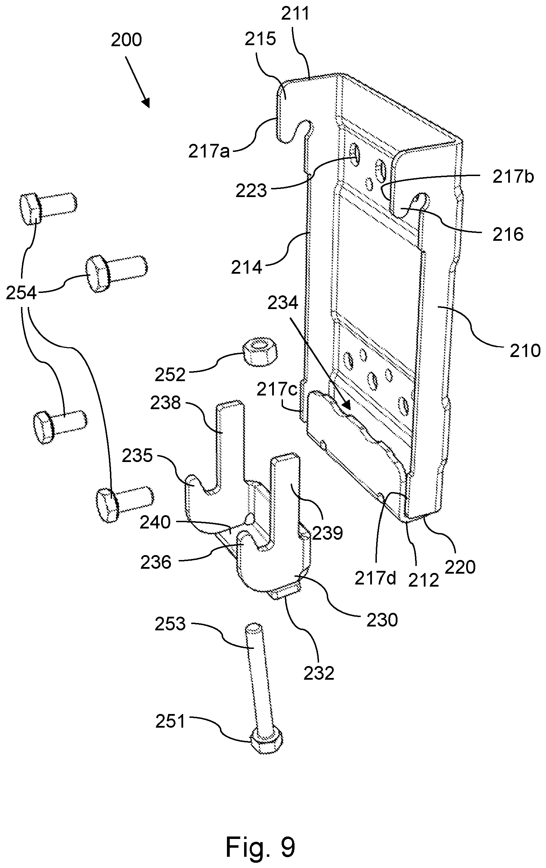

A mounting bracket 200 for use with the mounting rail 100 for mounting a piece of equipment 1 to a structure 2 is illustrated in greater detail in Fig. 9. The mounting bracket 200 comprises a first part 210 having a front side 213 configured to be attached to the piece of equipment 1. It further comprises an opposite back side 214 configured to face the mounting rail 100. The first part 210 has an upper end 211 comprising at least one upper hook-shaped portion 215, 216, herein two spaced-apart upper hook shaped portions 215, 216, configured for engaging with the upper ridge 105 of the mounting rail 100.

The mounting bracket 200 further comprises a second part 230 having a lower end 232 comprising at least one lower hook-shaped portion 235, 236, herein two spaced-apart lower hook-shaped portions 235, 236, configured for engaging with the lower ridge 106 of the mounting rail 100. The second part 230 is lockingly attachable to a lower end 212 of the first part 210 so as to clamp the mounting bracket 200 to the mounting rail 100.

The first part 210 of the mounting bracket 200 may for the purpose of attaching its front side 213 to the piece of equipment 1 comprise an equipment mounting interface. The equipment mounting interface may e.g. comprise a plurality of holes 223 for attachment of the mounting bracket 200 to the piece of equipment 1 using fastening devices 254 such as screws or similar.

Figs. 5-6 show the mounting rail 100 with two mounting brackets 200 mounted thereto in the second orientation, i.e. to the second bracket mounting interface. As illustrated herein, the second bracket mounting interface of the mounting rail 100 may comprise a plurality of regularly spaced openings 110a, 110b formed in the front side 103 of the mounting rail 100. Each opening 110a, 110b may comprise at least one transverse edge 111a, 111b, 114a, 114b extending in a transverse direction T perpendicular to the longitudinal direction L. The transverse edges 111a, 111b, 114a, 114b are configured for engaging with upper and lower hook shaped portions 215, 216, 235, 236 of the mounting bracket 200. The regularly spaced openings 110a, 110b are positioned and dimensioned so that the hook shaped portions 215, 216, 235, 236 of the mounting bracket 200 can lockingly engage with the transverse edges 111a, 111b, 114a, 114b of the openings 110. The openings 110a, 110b are herein identical, although this is of course not necessary. Furthermore, the openings 110a, 110b are herein shown with rounded corners, which is beneficial from a production point of view, but which is not necessary. The openings 110a, 110b should be dimensioned such that the hook shaped portions 215, 215, 235, 236 of the mounting bracket 200 can rest on a straight portion of the opening's edge. When the corners are rounded, a radius of curvature is preferably made as small as possible to provide a larger degree of freedom in the positioning of the mounting brackets 200 in the second orientation.

The plurality of regularly spaced openings 110a, 110b may comprise at least two pairs of openings, each pair of openings comprising an upper opening 110a and a lower opening 110b, wherein the upper opening 110a is closer to the upper end 101 of the mounting rail 100 than the lower opening 110b is, and wherein the pairs of openings are separated from one another in the longitudinal direction L. "Upper" and "lower" herein refer to the transverse direction T. In other words, the openings 110a, 110b are spaced apart in the longitudinal direction L as well as in the transverse direction T. In the illustrated embodiment, a first pair of openings 110a', 110b' and a second pair of openings 110a". 110b" are active, i.e., used for mounting the mounting bracket 200. In the illustrated embodiment, the longitudinal spacing between each pair of openings 110a, 110b is half of the longitudinal spacing between two active pairs of openings 110a', 110b', 110a", 110b". Thus, another pair of openings is provided halfway between the first and second pairs 110a', 110b', 110a", 110b". The longitudinal distance between the pairs of openings should be set small enough to achieve a versatile bracket mounting interface, but large enough not to compromise the strength of the mounting rail 100. No pair of openings, or one pair of openings, or several pairs of openings, may be provided between two active pairs of openings. By making the distance between adjacent pairs of openings as small as possible, a larger number of possible mounting positions for the mounting bracket 200 in the second orientation is achieved.

In the first orientation, the mounting bracket 200 may slide along the upper and lower ridges 105, 106 prior to securing the mounting bracket 200. Thus, the mounting bracket 200 can in principle be positioned anywhere along the mounting rail 100 when in the first orientation.

In alternative embodiments, not illustrated in the drawings, each pair of openings 110a, 110b as shown herein may be exchanged for a single opening. However, by providing pairs of openings, a stronger mounting rail 100 is provided.

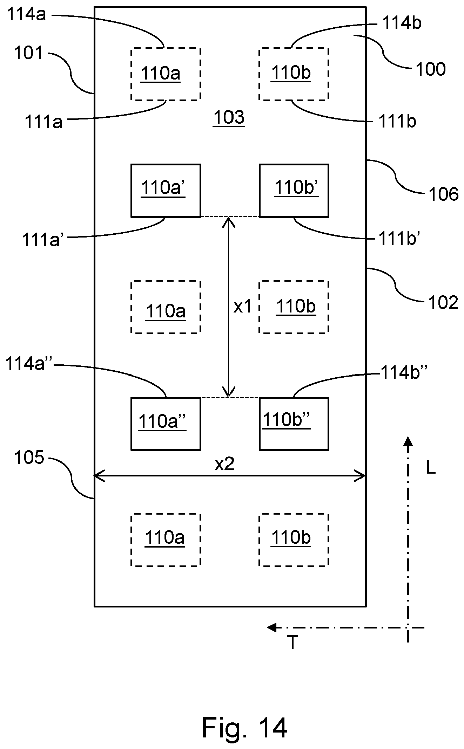

Reference is now also made to Fig. 14, which is a schematic view of the front side 103 of the mounting rail 100. As shown therein, the pairs of openings 110a, 110b may comprise a first pair 110a', 110b' and a second pair 110a", 110b", wherein the first pair 110a', 110b' comprises first transverse edges 111a', 111b' configured for engaging with an upper set of hook shaped portions 215, 216 of the mounting bracket 200. The second pair 110a", 110b" may comprise second transverse edges 114a", 114b" configured for engaging with an opposing lower set of hook shaped portions 235, 236 of the mounting bracket 200. A longitudinal distance x1 between the first transverse edges 111a', 111b' of the first pair 110a', 110b' and the second transverse edges 114a", 114b" of the second pair 110a", 110b" may be equal to a transverse distance x2 between the upper ridge 105 and the lower ridge 106 of the mounting rail 100, or it may differ from the transverse distance x2 between the upper ridge 105 and the lower ridge 106 by no more than ±15%, preferably by no more than ±10%, more preferably by no more than ±7%. However, the maximum possible difference between the longitudinal distance x1 and the transverse distance x2 depends on how much it is possible to adjust the second part 230 of the mounting bracket 200 with respect to the first part 210, as will be further discussed in connection with the description of the mounting bracket 200.

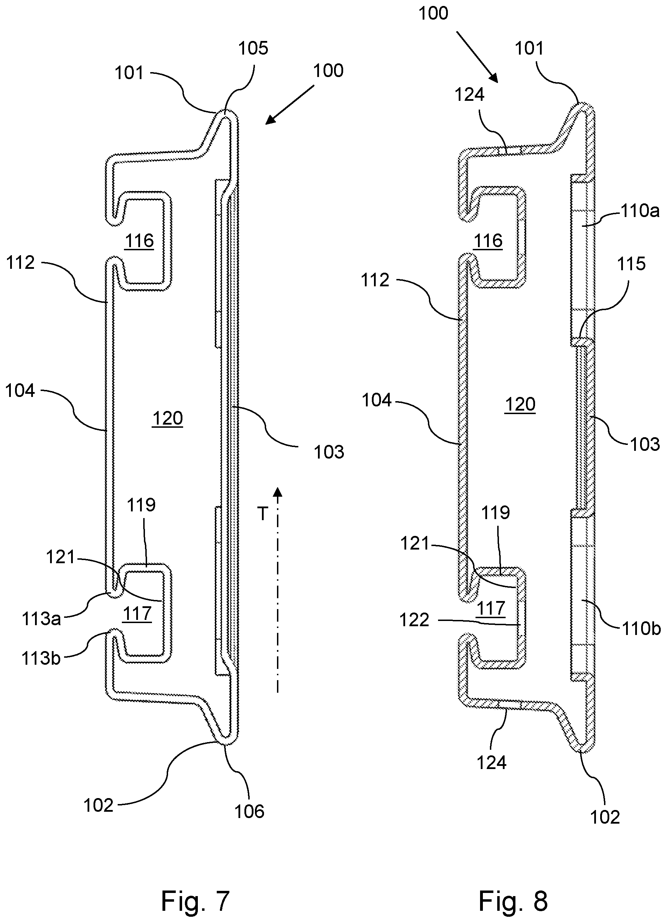

The mounting rail 100 is in the illustrated embodiments a hollow profile formed from a metal sheet, such as a steel sheet. This is most clearly seen in Fig. 7, illustrating the mounting rail 100 in an end view from the longitudinal direction, and in Fig. 8, illustrating the mounting rail 100 in a sectional view, the section being cut perpendicular to the longitudinal direction L through the openings 110a, 110b. The mounting rail 100 thus has an internal space 120 extending between the front and back sides 103, 104 and between the upper and lower ends 101, 102. Thanks to the hollow profile of the mounting rail 100 and the openings 110a, 110b provided therein, enabling vertical mounting of the pieces of equipment 1 with the mounting bracket 200 in the second orientation, hoisting of the mounting rail 100 with the pieces of equipment 1 mounted thereto off ground is greatly facilitated. A wire, rope, or similar may be threaded through a pair of "free" openings 110a, 110b and the mounting rail 100 with the pieces of equipment 1 mounted thereto may be hoisted off ground. With vertical mounting, the entire arrangement including the mounting rail 100 and the pieces of equipment 1 will be more stable than in a horizontal configuration.

The metal sheet used to form the mounting rail 100 may preferably be a steel sheet. The metal sheet, e.g. the steel sheet, may be roll formed to form the mounting rail, offering a relatively high precision and the possibility to use relatively thin sheets in comparison with e.g. bending or press forming. The metal sheet, such as the steel sheet, may advantageously be about 2 mm thick, such as 1-3 mm thick, or 1.5-2.5 mm thick, preferably 2 mm thick. The hollow profile saves weight and material, thus contributing to cost efficiency and reduced carbon dioxide emissions, in particular when steel is used to form the mounting rail 100 instead of, e.g., aluminium. By using a roll formed steel sheet, a strong yet thin and light mounting rail 100 is thereby achieved. When a roll formed steel sheet is used, the steel sheet has advantageously been galvanized after roll forming so as to provide corrosion protection. This also reduces the risk of corrosive stains forming on the structure 2 to which the mounting rail 100 is mounted.

The metal sheet may be formed to define a single-layer outer wall 112 of the mounting rail as illustrated in Figs. 7-8. A welding joint (not illustrated) joining opposite edge portions of the metal sheet may extend along the mounting rail 100, the welding joint being formed at the back side 104 of the mounting rail 100. Contacting overlap of edges of the metal sheet should preferably be avoided in order to minimize passive intermodulation (PIM). Likewise, contact between different portions of the outer wall 112 should preferably be avoided. In the illustrated embodiments, the mounting rail 100 is consequently formed with a single layer outer wall 112 delimiting the internal space 120. In other words, the mounting rail 100 is formed so that no portion of the outer wall 112 contacts any other portion of the outer wall 112. The openings 110a, 110b are formed in the outer wall 112. In areas located longitudinally between the openings 110a, 110b, the outer wall 112 is continuous, i.e., in those areas there is no gap present in a circumference of the mounting rail 100. This results in a good torsional rigidity.

Elongated recesses 118 may be formed in the front side 103, extending in the transverse direction T. The elongated recess 118 has a reinforcing function. In the shown embodiments, such a recess 118 is provided between each adjacent pairs of openings 110a, 110b.

Each one of the plurality of regularly spaced openings 110a, 110b may be delimited by a collar 115 extending into an internal space 120 provided between the front side 103 and the back side 104 of the mounting rail 100, as shown in Fig. 8. The collar 115 reinforces the mounting rail 100 and extends around a circumference of the opening 110a, 110b. It also softens the edges of the openings 110a, 110b, thus mitigating the risk of cutting injuries during mounting of the equipment. The collar 115 further supports the hook shaped portions 115, 116, 135, 136 of the mounting bracket 200 when mounted to the second bracket mounting interface. The collar 115 is not in contact with the back side 104 of the mounting rail 100.

In the illustrated embodiments, the structure mounting interface comprises an upper T-shaped groove 116 and a lower T-shaped groove 117 formed in the back side 104, each groove 116, 117 extending in the longitudinal direction L of the mounting rail 100. The T-shaped grooves 116, 117 are advantageously aligned with the openings formed in the front side 103. The T-shaped grooves 116, 117 are advantageously formed by roll forming, wherein the metal sheet is formed to define the shape of the grooves 116, 117. Each groove 116, 117 is delimited by a wall portion 119 forming part of the outer wall 112. The wall portion 119 is formed not to be in contact with any other portion of the outer wall 112, and a space provided between the wall portion 119 and the remaining part of the outer wall 112 should be sufficient to ensure that the entire outer wall 112 can be galvanized.

Each T-shaped groove 116, 117 has a narrow opening delimited by upper and lower rims 113a, 113b and a wider interior as measured in the transverse direction T. Thereby, a nut or a head of a fastening device, such as a square nut or a square head, may be slidably fitted in the wider interior of the groove. The nut or head is dimensioned to be prevented from rotating within the groove 116, 117. When the fastening device is tightened, the "folded" outer wall 112 provides a spring bias, reducing the risk that the fastening device loosens after attachment.

Each T-shaped groove 116, 117 herein comprises a bottom 121 in which a plurality of through-holes 122 for attaching the mounting rail 100 to a structure such as a wall or similar are formed, each through-hole 122 being accessible from the front side 103 via one of the regularly spaced openings 110a, 110b. This facilitates mounting to a wall or another structure using fastening devices such as screws or nails. Furthermore, at the same longitudinal positions as the openings 110a, 110b, through-holes 124 are provided close to the upper end 101 and the lower end 102 of the mounting rail 100, intended for the fastening of cables (not shown) using straps or similar.

The welding joint preferably extends halfway between the T-shaped grooves 116, 117, i.e., at the middle of the back side 104, since this placement has been found to be beneficial for the strength of the mounting rail 100.

Reference is now made to Figs. 9-10, showing the mounting bracket 200, including its first part 210 and its second part 230, in greater detail. The mounting bracket 200 herein further comprises a fastening device 251, 252. The second part 230 is configured to be attached to the first part 210 by the fastening device 251, 252. The fastening device 251, 252 is configured to enable adjustment of a distance between the upper end 211 of the first part 210 and the lower end 232 of the second part 230. The fastening device 251, 252 herein comprises a male fastening member 251 in the form of a screw or bolt 251 and a female fastening member in the form of a nut 252, wherein the male fastening member 251 has a straight shaft 253.

The second part 230 is thus telescopically movable with respect to the first part 210 so as to adjust a distance between the upper hook shaped portions 215, 216 and the lower hook shaped portions 235, 236, enabling clamping of the mounting bracket to the first or second bracket mounting interface of the mounting rail 100. The fastening device 251, 252 and the telescopically movable second part 230 further allows adjustment to slightly differing sizes of the bracket mounting interfaces. Alignment portions 238, 239 of the second part 230 are used for aligning the second part 230 to the first part 210 during adjustment of the distance.

The lower end 212 of the first part 210 herein comprises a first floor 220 in which a first through-hole is provided, and the lower end 232 of the second part 230 comprises a second floor 240 in which a second through-hole is provided. The first and second through-holes are configured for receiving the straight shaft 253 of the fastening device 251, i.e. of the screw or bolt 251.

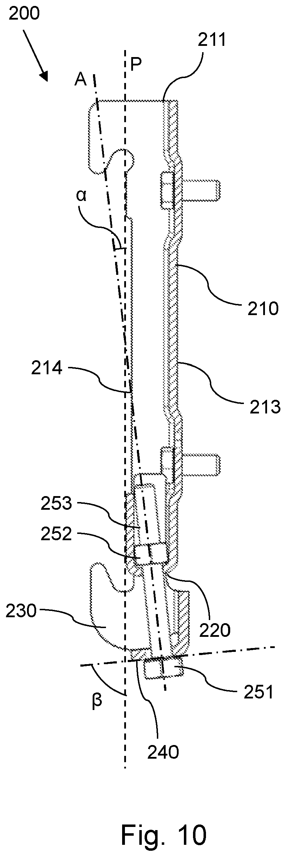

The first and second through-holes are herein arranged to define an axis A extending at an angle α, such as an angle α of 5-15°, with respect to a mounting rail contact plane P defined by contact surfaces 217a-d provided on the back side 214 of the first part 210, such that the straight shaft 253 extends downward and forward from the first through-hole. "Forward" is herein a direction from the back side 214 toward the front side 213. In other words, the mounting bracket 200 is configured to receive the straight shaft 253 extending at an angle with respect to the contact plane P, with a lower end of the fastening, including a head of the screw or bolt 251, protruding downward/forward to facilitate fastening to the mounting rail 100 using a mounting tool, such as a wrench or screw driver. This is illustrated in Fig. 10, showing the mounting bracket 200 in a sectional view.

When the mounting bracket 200 is mounted to the mounting rail 100, the contact plane P is parallel to the transverse direction T as well as to the longitudinal direction L of the mounting rail 100.

At least the second floor 240 may be formed at an angle β, such as an angle β of 75-85°, with respect to the mounting rail contact plane P as illustrated in the sectional view in Fig. 10. Advantageously, the first and second floors 220, 240 are both formed at the same angle β with respect to the mounting rail contact plane P. This applies when the mounting bracket 200 is mounted to the mounting rail 100 with the second part 230 attached to the first part 210.

The lower end 212 of the first part 210 may as illustrated herein comprise a pocket 234 configured to lockingly receive a first fastening member 252 of the fastening device 251, 252, such as the female fastening member 252 of the fastening device 251, 252. The pocket is dimensioned to prevent rotation of the female fastening member 252. Of course, the fastening device 251, 252 may instead be attached with a head of the male fastening member 251 inside the pocket 234 and with the shaft 253 receiving the female fastening member 251 protruding therefrom. However, by fitting the female fastening member 251 within the pocket 234, the protrusion of the fastening device 251, 252 from the mounting bracket can be minimized. This results in a more stable arrangement when the mounting bracket 200 is attached to the piece of equipment 1 prior to mounting on the mounting rail 100. With minimal protrusion of the fastening device, the risk that the arrangement including the piece of equipment 1 and the mounting bracket 200 falls over if temporarily put on the ground is reduced. Furthermore, with the female fastening member 252 provided in the pocket 234, the mounting bracket 200 is easier to mount on the mounting rail 200 since the head of the male fastening member 251 is normally easier to manipulate during tightening .

The back side 214 of the first part 210 may comprise four spaced-apart contact surfaces 217a-d configured to abut the mounting rail (100). The contact surfaces 217a-d together define the mounting rail contact plane P. By providing spaced-apart contact surfaces, a stable contact interface and a reduced risk of PIM is achieved.

Both the first and the second parts 210, 230 of the mounting bracket 200 may be formed from a respective metal sheet, such as a steel sheet. The metal sheet, e.g. the steel sheet, may be thicker than the steel sheet used to form the mounting rail 100. The metal sheets may be bent or pressed to form the parts 210, 230 of the mounting bracket 200, in contrast to the mounting rail 100, which is advantageously roll formed. When the mounting rail has a wall thickness of approximately 2 mm, a goods thickness of the mounting bracket 200 may be 3-4 mm. By using a metal sheet thicker than that of the mounting rail, the hook shaped portions 215, 216, 235, 236 can be made smaller. This in turns means that the openings 110 of the mounting rail 100 can be made smaller, thereby enabling a smaller spacing between adjacent pairs of openings in the mounting rail 100 with retained strength. This offers a greater freedom to position the mounting brackets 200 on the mounting rail 100 in the second orientation.

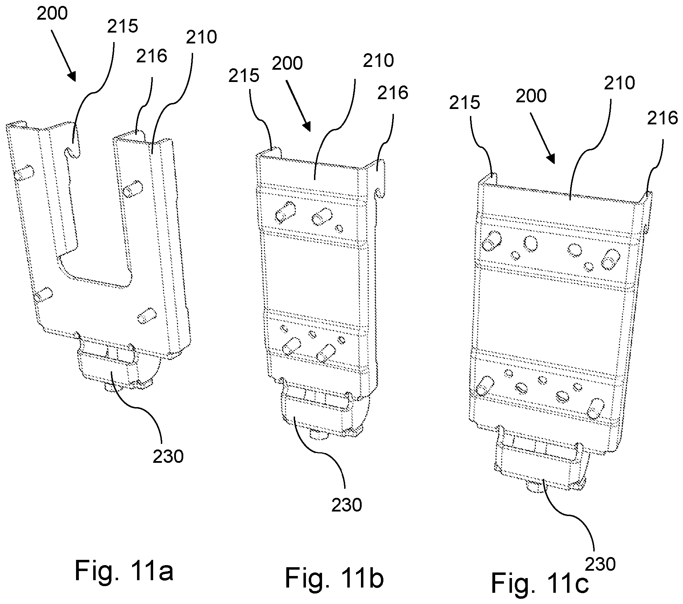

Figs. 11a-11c show mounting brackets 200 according to three different example embodiments having different widths, useful for mounting pieces of equipment 1 of different dimensions. It is to be noted that only the first parts 210 of the mounting brackets 200 differ, while as identical second parts 230 are used for all three dimensions of the first part 210. The distance between the upper hook-shaped portions 215, 216 are in all three embodiments adapted to fit into the openings 110a, 110b of the mounting rail 100, so that mounting to the first as well as to the second bracket mounting interface is possible. In the widest embodiment shown in Fig. 11a, the total width of the mounting bracket 200 is larger than a distance between outer edges of the openings 110a, 110b in the mounting rail 100. For this reason, the first part 210 is herein U-shaped with the upper hook-shaped portions 215, 216 being provided at an inside of the "legs".

When made from steel sheets, the mounting bracket 200 is preferably galvanized to provide corrosion protection.

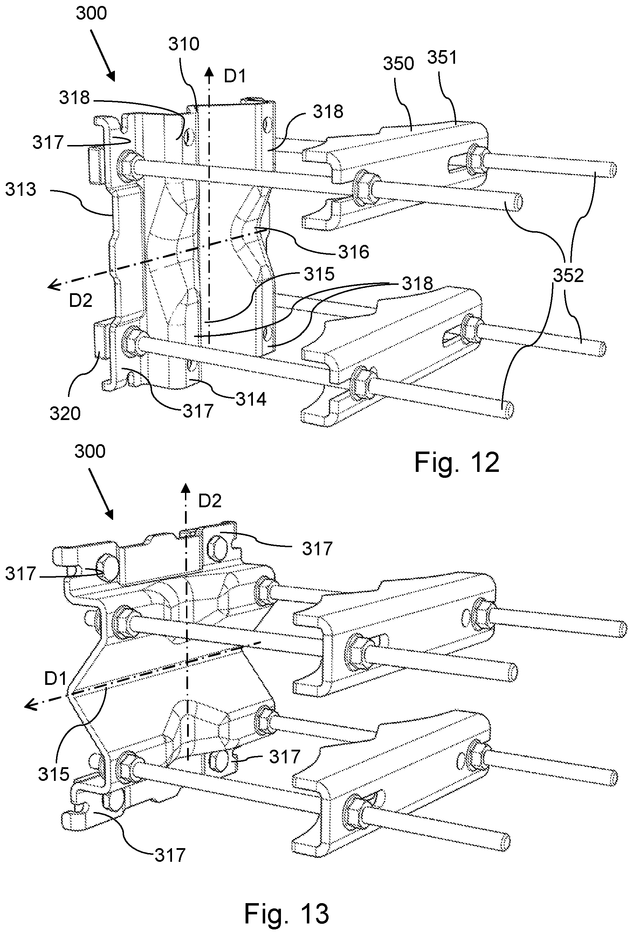

Reference is now made to Figs. 12-13, showing the mounting kit 300 for mounting the mounting rail 100 to a pole 2 in greater detail. The mounting kit 300 comprises a pole adapter 310 configured to be attached to the mounting rail 100 with a front side 313 of the pole adapter 310 facing the back side 104 of the mounting rail 100 and with a back side 314 of the pole adapter 310 facing the pole 2. The pole adapter 310 is formed such that it can rest stably against the pole 2 in a first orientation, shown in Fig. 12, and in a second orientation, shown in Fig. 13, the second orientation being perpendicular to the first orientation.

The mounting kit 300 further comprises an attachment device 350 for attaching the pole adapter 310 to the pole 2 in at least one of the first and second orientations.

The pole adapter 310 is herein formed to define a first recess 315 extending in a first direction D1 and a second recess 316 extending in a second direction D2 perpendicular to the first direction D1, wherein both recesses 315, 316 are formed in the back side 314 of the pole adapter 310 and are configured for receiving at least a portion of the pole 2.

The pole adapter 310 is advantageously formed from a metal sheet, such as a steel sheet. Similarly to the mounting bracket 200, the pole adapter 310 may be formed from a thicker metal sheet, e.g. steel sheet, than the mounting rail 100. The pole adapter 310 may e.g. be press formed. The thickness of the sheet may be similar as that of the mounting bracket 200.

The pole adapter 310 may comprise a first attachment interface for engaging with the attachment device 350 in the first orientation of the pole adapter 310, and a second attachment interface for engaging with the attachment device 350 in the second orientation of the pole adapter 310. The first and second orientations of the pole adapter 310 are herein defined with respect to the pole 2. Fig. 1 shows the pole adapter 310 mounted in the first orientation to the pole 2, and Fig. 2 shows the pole adapter 310 mounted in the second orientation to the pole 2. The orientation of the pole adapter 310 with respect to the mounting rail 100 is always the same.

The attachment device 350 according to a first embodiment, shown in Figs. 12-13, comprises a clamping member 351. The clamping member 351 and the pole adapter 310 are arranged to abut opposite sides of the pole 2. Four connection devices 352 comprising rods and nuts are used for connecting the clamping member to the pole adapter 310.

The first attachment interface, used for engaging with the attachment device 350 in the first orientation of the pole adapter 310, may comprise a set of four first through-holes, each one of the first through-holes being formed in a respective corner region 317 of the pole adapter 310. The first through-holes are in both orientations of the pole adapter 310 used for attaching the pole adapter to the T-shaped grooves 116, 117 of the mounting rail 100. Fastening members 320 in the form of square nuts are used for this purpose. In the first orientation, the fastening members 320 may be engaged with the rods of the connection devices 352. In the second orientation, separate screws may be used as illustrated in Fig. 13. Thus, the first attachment interface is herein configured to be used for attachment of the pole adapter 310 to the mounting rail 100, and the pole adapter 310 is further configured to be attached to the mounting rail 100 by means of fastening members 320 being locked for rotation within the T-shaped grooves 116, 117 of the mounting rail 100.

The pole adapter 310 herein further comprises four crest regions 318 spaced apart by the first and second recesses, respectively. The second attachment interface comprises a set of four second through-holes, wherein each one of the second through-holes is formed in a respective one of the crest regions 318. The same attachment device 350 may be used for attaching the mounting rail 100 to the pole 2 in the first and second orientations, respectively.

The crest regions 318 may extend between the corner regions 317 and the first recess 315, the corner regions 318 being recessed with respect to the crest regions 318. Thus, the front side 313 of the pole adapter 310 abuts the mounting rail 100 at the corner regions 318.

An attachment device 350' according to a second embodiment is illustrated in Figs. 5-6. The attachment device 350' is in the form of an adjustable strap, such as an adjustable metal strap, that may be used for mounting of the pole adapter 310 to poles 2 that are too wide to be used with the attachment device 350 according to the first embodiment. The first recess 315 may be deeper than the second recess 316. The more shallow second recess 316 thereby allows the adjustable strap to be introduced between the pole adapter 310 and the mounting rail 100. Two straps may be used instead of a single strap, one on each side of the first recess 315.

When using the word "comprise" or "comprising" it shall be interpreted as non-limiting, i.e. meaning "consist at least of".

The embodiments herein are not limited to the above described preferred embodiments.

Various alternatives, modifications may be used.

## Claims

1. A mounting rail (100) for mounting of a piece of equipment (1) to a structure (2), the piece of equipment (1) being provided with a mounting bracket (200), the mounting rail (100) comprising:
- an upper end (101) and an opposite lower end (102) extending in a longitudinal direction (L) of the mounting rail (100),
- a front side (103) and an opposite back side (104), both the front side (103) and the back side (104) extending between said upper and lower ends (101, 102),
wherein the back side (104) comprises at least one structure mounting interface for attaching the mounting rail (100) to the structure,
wherein the upper end (101) comprises an upper ridge (105) and wherein the lower end (102) comprises a lower ridge (106), the upper and lower ridges (105, 106) extending along the mounting rail (100) and forming a first bracket mounting interface for mounting the mounting bracket (200) to the front side (103) of the mounting rail (100) in a first orientation, and **characterized in that**
the front side (103) comprises a second bracket mounting interface for mounting the mounting bracket (200) to the front side (103) of the mounting rail (100) in a second orientation perpendicular to the first orientation.

2. The mounting rail (100) according to claim 1, wherein the second bracket mounting interface comprises a plurality of regularly spaced openings (110a, 110b) formed in the front side (103) of the mounting rail (100).

3. The mounting rail (100) according to claim 2, wherein each opening (110a, 110b) comprises at least one transverse edge (111) extending in a transverse direction (T) perpendicular to the longitudinal direction (L).

4. The mounting rail (100) according to claim 2 or 3, wherein the plurality of regularly spaced openings (110a, 110b) comprises at least two pairs of openings, each pair of openings comprising an upper opening (110a) and a lower opening (110b), wherein the upper opening (110a) is closer to the upper end (101) of the mounting rail (100) than the lower opening (110b) is, and wherein the pairs of openings are separated from one another in the longitudinal direction (L).

5. The mounting rail (100) according to any one of the preceding claims, wherein the mounting rail (100) is a hollow profile formed from a metal sheet, such as a steel sheet.

6. The mounting rail (100) according to any one of the preceding claims, wherein the structure mounting interface comprises an upper T-shaped groove (116) and a lower T-shaped groove (117) formed in the back side (104), each groove (116, 117) extending in the longitudinal direction (L) of the mounting rail (100).

7. A mounting bracket (200) for use with the mounting rail (100) according to any one of the preceding claims for mounting a piece of equipment (1) to a structure (2), wherein the mounting bracket (200) comprises:
- a first part (210) having a front side (213) configured to be attached to the piece of equipment (1) and an opposite back side (214) configured to face the mounting rail (100), the first part (210) having an upper end (211) comprising at least one hook-shaped portion (215, 216) configured for engaging with the upper ridge (105) of the mounting rail (100), and
- a second part (230) having a lower end (232) comprising at least one lower hook-shaped portion (235, 236) configured for engaging with the lower ridge (106) of the mounting rail (100),
- wherein the second part (230) is lockingly attachable to a lower end (212) of the first part (210) so as to clamp the mounting bracket (200) to the mounting rail (100).

8. The mounting bracket (200) according to claim 7, wherein the upper end (211) of the first part (210) comprises at least two spaced-apart upper hook-shaped portions (215, 216), and wherein the lower end (232) of the second part (230) comprises at least two spaced-apart lower hook-shaped portions (235, 236).

9. The mounting bracket (200) according to claim 7 or 8, further comprising a fastening device (251, 252), wherein the second part (230) is configured to be attached to the first part (210) by the fastening device (251, 252), and wherein the fastening device (251, 252) is configured to enable adjustment of a distance between the upper end (211) of the first part (210) and the lower end (232) of the second part (230).

10. The mounting bracket (200) according to claim 9, wherein the lower end (212) of the first part (210) comprises a first floor (220) in which a first through-hole is provided, and wherein the lower end (232) of the second part (230) comprises a second floor (240) in which a second through-hole is provided, wherein the first and second through-holes are configured for receiving a straight shaft (253) of the fastening device (251, 252).

11. The mounting bracket (200) according to claim 10, wherein the first and second through-holes are arranged to define an axis extending at an angle (α) with respect to a mounting rail contact plane (P) defined by contact surfaces (217a-d) provided on the back side (214) of the first part (210), such that the straight shaft (253) extends downward and forward from the first through-hole.

12. The mounting bracket (200) according to any one of claims 9-11, wherein the lower end (212) of the first part (210) comprises a pocket (234) configured to lockingly receive a first fastening member (252) of the fastening device (251, 252), such as a female fastening member (252) of the fastening device (251, 252).

13. A mounting kit (300) for mounting the mounting rail (100) according to any one of claims 1-6 to a pole (2), wherein the mounting kit (300) comprises:
- a pole adapter (310) configured to be attached to the mounting rail (100) with a front side (313) of the pole adapter (310) facing the mounting rail (100) and with a back side (314) of the pole adapter (310) facing the pole (2), wherein the pole adapter (310) is formed such that it can rest stably against the pole (2) in a first orientation and in a second orientation, the second orientation being perpendicular to the first orientation,
- an attachment device (350) for attaching the pole adapter (310) to the pole (2) in at least one of the first and second orientations.

14. The mounting kit (300) according to claim 13, wherein the pole adapter (310) is formed to define a first recess (315) extending in a first direction (D1) and a second recess (316) extending in a second direction (D2) perpendicular to the first direction (D1), wherein both recesses (315, 316) are formed in the back side (314) of the pole adapter (310) and are configured for receiving at least a portion of the pole (2).

15. A mounting system (400) comprising the mounting rail (100) according to any one of claims 1-6 and the mounting bracket (200) according to any one of claims 7-12, wherein the mounting bracket (200) is configured to be attached in the first orientation to the first bracket mounting interface of the mounting rail (100), and wherein the mounting bracket (200) is configured to be attached in the second orientation to the second bracket mounting interface of the mounting rail (100).

16. The mounting system (400) according to claim 15, further comprising the mounting kit (300) according to any one of claims 13-14.

## Patentansprüche

1. Montageschiene (100) zum Befestigen eines Ausrüstungsgegenstandes (1) an einer Struktur (2), wobei der Ausrüstungsgegenstand (1) mit einer Montagehalterung (200) versehen ist, wobei die Montageschiene (100) Folgendes umfasst:
- ein oberes Ende (101) und ein entgegengesetztes unteres Ende (102), die sich in einer Längsrichtung (L) der Montageschiene (100) erstrecken,
- eine Vorderseite (103) und eine entgegengesetzte Rückseite (104), wobei sich sowohl die Vorderseite (103) als auch die Rückseite (104) zwischen dem oberen und dem unteren Ende (101, 102) erstrecken,
wobei die Rückseite (104) mindestens eine Strukturmontageschnittstelle zum Befestigen der Montageschiene (100) an der Struktur umfasst,
wobei das obere Ende (101) einen oberen Steg (105) umfasst und das untere Ende (102) einen unteren Steg (106) umfasst, wobei sich der obere und der untere Steg (105, 106) entlang der Montageschiene (100) erstrecken und eine erste Halterungsmontageschnittstelle zum Montieren der Montagehalterung (200) an der Vorderseite (103) der Montageschiene (100) in einer ersten Ausrichtung bilden, und **dadurch gekennzeichnet, dass**
die Vorderseite (103) eine zweite Halterungsmontageschnittstelle zum Montieren der Montagehalterung (200) an der Vorderseite (103) der Montageschiene (100) in einer zweiten Ausrichtung, senkrecht zur ersten Ausrichtung, umfasst.

2. Montageschiene (100) nach Anspruch 1, wobei die zweite Halterungsmontageschnittstelle eine Vielzahl von regelmäßig beabstandeten Öffnungen (110a, 110b) umfasst, die in der Vorderseite (103) der Montageschiene (100) ausgebildet sind.

3. Montageschiene (100) nach Anspruch 2, wobei jede Öffnung (110a, 110b) mindestens eine Querkante (111) aufweist, die sich in einer Querrichtung (T), senkrecht zur Längsrichtung (L), erstreckt.

4. Montageschiene (100) nach Anspruch 2 oder 3, wobei die Vielzahl von regelmäßig beabstandeten Öffnungen (110a, 110b) mindestens zwei Paare von Öffnungen umfasst, wobei jedes Paar von Öffnungen eine obere Öffnung (110a) und eine untere Öffnung (110b) umfasst, wobei die obere Öffnung (110a) näher am oberen Ende (101) der Montageschiene (100) liegt als die untere Öffnung (110b) und wobei die Paare von Öffnungen in der Längsrichtung (L) voneinander getrennt sind.

5. Montageschiene (100) nach einem der vorstehenden Ansprüche, wobei die Montageschiene (100) ein Hohlprofil ist, das aus einem Metallblech, beispielsweise einem Stahlblech, geformt ist.

6. Montageschiene (100) nach einem der vorstehenden Ansprüche, wobei die Strukturmontageschnittstelle eine obere T-förmige Nut (116) und eine untere T-förmige Nut (117), die in der Rückseite (104) ausgebildet sind, umfasst, wobei sich jede Nut (116, 117) in der Längsrichtung (L) der Montageschiene (100) erstreckt.

7. Montagehalterung (200) zur Verwendung mit der Montageschiene (100) nach einem der vorstehenden Ansprüche zum Befestigen eines Ausrüstungsgegenstandes (1) an einer Struktur (2), wobei die Montagehalterung (200) Folgendes umfasst:
- ein erstes Teil (210), das eine Vorderseite (213), die dafür konfiguriert ist, an dem Ausrüstungsgegenstand (1) befestigt zu werden, und eine entgegengesetzte Rückseite (214), die so konfiguriert ist, dass sie der Montageschiene (100) zugewandt ist, aufweist, wobei das erste Teil (210) ein oberes Ende (211) aufweist, das mindestens einen hakenförmigen Abschnitt (215, 216) umfasst, der zum Ineinandergreifen mit dem oberen Steg (105) der Montageschiene (100) konfiguriert ist, und
- ein zweites Teil (230), das ein unteres Ende (232) aufweist, das mindestens einen unteren hakenförmigen Abschnitt (235, 236) umfasst, der zum Ineinandergreifen mit dem unteren Steg (106) der Montageschiene (100) konfiguriert ist,
- wobei der zweite Teil (230) verriegelbar an einem unteren Ende (212) des ersten Teils (210) befestigt werden kann, um so die Montagehalterung (200) an der Montageschiene (100) festzuklemmen.

8. Montagehalterung (200) nach Anspruch 7, wobei das obere Ende (211) des ersten Teils (210) mindestens zwei beabstandete obere hakenförmige Abschnitte (215, 216) umfasst und wobei das untere Ende (232) des zweiten Teils (230) mindestens zwei beabstandete untere hakenförmige Abschnitte (235, 236) umfasst.

9. Montagehalterung (200) nach Anspruch 7 oder 8, weiter umfassend eine Befestigungsvorrichtung (251,252), wobei der zweite Teil (230) dafür konfiguriert ist, durch die Befestigungsvorrichtung (251,252) an dem ersten Teil (210) befestigt zu werden, und wobei die Befestigungsvorrichtung (251,252) dafür konfiguriert ist, eine Einstellung eines Abstands zwischen dem oberen Ende (211) des ersten Teils (210) und dem unteren Ende (232) des zweiten Teils (230) zu ermöglichen.

10. Montagehalterung (200) nach Anspruch 9, wobei das untere Ende (212) des ersten Teils (210) einen ersten Boden (220) umfasst, in dem eine erste Durchgangsbohrung bereitgestellt ist, und wobei das untere Ende (232) des zweiten Teils (230) einen zweiten Boden (240) umfasst, in dem eine zweite Durchgangsbohrung bereitgestellt ist, wobei die erste und die zweite Durchgangsbohrung zum Aufnehmen eines geraden Schafts (253) der Befestigungsvorrichtung (251, 252) konfiguriert sind.

11. Montagehalterung (200) nach Anspruch 10, wobei die erste und die zweite Durchgangsbohrung so angeordnet sind, dass sie eine Achse definieren, die sich in einem Winkel (α) zu einer Montageschienen-Kontaktebene (P) erstreckt, die durch Kontaktflächen (217a-d) auf der Rückseite (214) des ersten Teils (210) definiert wird, sodass sich der gerade Schaft (253) von der ersten Durchgangsbohrung aus nach unten und nach vorne erstreckt.

12. Montagehalterung (200) nach einem der Ansprüche 9-11, wobei das untere Ende (212) des ersten Teils (210) eine Tasche (234) umfasst, die dafür konfiguriert ist, ein erstes Befestigungselement (252) der Befestigungsvorrichtung (251, 252), wie beispielsweise ein aufnehmendes Befestigungselement (252) der Befestigungsvorrichtung (251, 252), verriegelnd aufzunehmen.

13. Montagesatz (300) zum Befestigen der Montageschiene (100) nach einem der Ansprüche 1-6 an einer Stange (2), wobei der Montagesatz (300) Folgendes umfasst:
- einen Stangenadapter (310), der dafür konfiguriert ist, an der Montageschiene (100) befestigt zu werden, wobei eine Vorderseite (313) des Stangenadapters (310) der Montageschiene (100) zugewandt ist und wobei eine Rückseite (314) des Stangenadapters (310) der Stange (2) zugewandt ist, wobei der Stangenadapter (310) so geformt ist, dass er in einer ersten Ausrichtung und in einer zweiten Ausrichtung stabil an der Stange (2) anliegen kann, wobei die zweite Ausrichtung senkrecht zur ersten Ausrichtung ist,
- eine Befestigungsvorrichtung (350) zum Befestigen des Stangenadapters (310) an der Stange (2) in mindestens einer von der ersten und der zweiten Ausrichtung.

14. Montagesatz (300) nach Anspruch 13, wobei der Stangenadapter (310) dafür konfiguriert ist, eine erste Aussparung (315), die sich in einer ersten Richtung (D1) erstreckt, und eine zweite Aussparung (316), die sich in einer zweiten Richtung (D2), senkrecht zur ersten Richtung (D1), erstreckt, zu definieren, wobei beide Aussparungen (315, 316) in der Rückseite (314) des Stangenadapters (310) ausgebildet sind und zum Aufnehmen mindestens eines Abschnitts der Stange (2) konfiguriert sind.

15. Montagesystem (400), umfassend die Montageschiene (100) nach einem der Ansprüche 1-6 und die Montagehalterung (200) nach einem der Ansprüche 7 bis 12, wobei die Montagehalterung (200) dafür konfiguriert ist, in der ersten Ausrichtung an der ersten Halterungsmontageschnittstelle der Montageschiene (100) befestigt zu werden, und wobei die Montagehalterung (200) dafür konfiguriert ist, in der zweiten Ausrichtung an der zweiten Halterungsmontageschnittstelle der Montageschiene (100) befestigt zu werden.

16. Montagesystem (400) nach Anspruch 15, weiter umfassend den Montagesatz (300) nach einem der Ansprüche 13-14.

## Revendications

1. Rail de montage (100) pour le montage d'un équipement (1) sur une structure (2), l'équipement (1) étant muni d'un support de montage (200), le rail de montage (100) comprenant :
- une extrémité supérieure (101) et une extrémité inférieure opposée (102) s'étendant dans une direction longitudinale (L) du rail de montage (100),
- une face avant (103) et une face arrière opposée (104), la face avant (103) et la face arrière (104) s'étendant toutes deux entre lesdites extrémités supérieure et inférieure (101, 102),
dans lequel la face arrière (104) comprend au moins une interface de montage de structure pour fixer le rail de montage (100) à la structure,
dans lequel l'extrémité supérieure (101) comprend une arête supérieure (105) et dans lequel l'extrémité inférieure (102) comprend une arête inférieure (106), les arêtes supérieure et inférieure (105, 106) s'étendant le long du rail de montage (100) et formant une première interface de montage pour monter le support de montage (200) sur la face avant (103) du rail de montage (100) dans une première orientation, et **caractérisé en ce que**
la face avant (103) comprend une deuxième interface de montage de support pour monter le support de montage (200) sur la face avant (103) du rail de montage (100) dans une deuxième orientation perpendiculaire à la première orientation.

2. Rail de montage (100) selon la revendication 1, dans lequel la deuxième interface de montage du support comprend une pluralité d'ouvertures régulièrement espacées (110a, 110b) formées sur la face avant (103) du rail de montage (100).

3. Rail de montage (100) selon la revendication 2, dans lequel chaque ouverture (110a, 110b) comprend au moins un bord transversal (111) s'étendant dans une direction transversale (T) perpendiculaire à la direction longitudinale (L).

4. Rail de montage (100) selon la revendication 2 ou 3, dans lequel la pluralité d'ouvertures régulièrement espacées (110a, 110b) comprend au moins deux paires d'ouvertures, chaque paire d'ouvertures comprenant une ouverture supérieure (110a) et une ouverture inférieure (110b), dans lequel l'ouverture supérieure (110a) est plus proche de l'extrémité supérieure (101) du rail de montage (100) que l'ouverture inférieure (110b), et dans lequel les paires d'ouvertures sont séparées l'une de l'autre dans la direction longitudinale (L).

5. Rail de montage (100) selon l'une quelconque des revendications précédentes, dans lequel le rail de montage (100) est un profil creux formé à partir d'une feuille de métal, telle qu'une feuille d'acier.

6. Rail de montage (100) selon l'une quelconque des revendications précédentes, dans lequel l'interface de montage de structure comprend une rainure supérieure en forme de T (116) et une rainure inférieure en forme de T (117) formées sur la face arrière (104), chaque rainure (116, 117) s'étendant dans la direction longitudinale (L) du rail de montage (100).

7. Support de montage (200) destiné à être utilisé avec le rail de montage (100) selon l'une quelconque des revendications précédentes pour le montage d'un équipement (1) sur une structure (2), dans lequel ledit support de montage (200) comprend :
- une première partie (210) présentant une face avant (213) configurée pour être fixée à l'équipement (1) et une face arrière opposée (214) configurée pour faire face au rail de montage (100), la première partie (210) présentant une extrémité supérieure (211) comprenant au moins une partie en forme de crochet (215, 216) configurée pour se mettre en prise avec le rebord supérieur (105) du rail de montage (100), et
- une deuxième partie (230) présentant une extrémité inférieure (232) comprenant au moins une partie inférieure en forme de crochet (235, 236) configurée pour s'engager avec la crête inférieure (106) du rail de montage (100),
- dans lequel la deuxième partie (230) est fixée de manière verrouillable à une extrémité inférieure (212) de la première partie (210) afin de fixer le support de montage (200) au rail de montage (100).

8. Support de montage (200) selon la revendication 7, dans lequel l'extrémité supérieure (211) de la première partie (210) comprend au moins deux parties supérieures en forme de crochet espacées (215, 216), et dans lequel l'extrémité inférieure (232) de la deuxième partie (230) comprend au moins deux parties inférieures en forme de crochet espacées (235, 236).

9. Support de montage (200) selon la revendication 7 ou 8, comprenant en outre un dispositif de fixation (251, 252), dans lequel la deuxième partie (230) est configurée pour être fixée à la première partie (210) par le dispositif de fixation (251, 252), et dans lequel le dispositif de fixation (251, 252) est configuré pour permettre le réglage d'une distance entre l'extrémité supérieure (211) de la première partie (210) et l'extrémité inférieure (232) de la seconde partie (230).

10. Support de montage (200) selon la revendication 9, dans lequel l'extrémité inférieure (212) de la première partie (210) comprend un premier plancher (220) dans lequel un premier trou traversant est prévu, et dans lequel l'extrémité inférieure (232) de la deuxième partie (230) comprend un deuxième plancher (240) dans lequel un deuxième trou traversant est prévu, les premier et deuxième trous traversants étant configurés pour recevoir un arbre droit (253) du dispositif de fixation (251, 252).

11. Support de montage (200) selon la revendication 10, dans lequel les premier et deuxième trous traversants sont disposés de manière à définir un axe s'étendant selon un angle (α) par rapport à un plan de contact du rail de montage (P) défini par des surfaces de contact (217a-d) prévues sur la face arrière (214) de la première partie (210), de sorte que l'arbre droit (253) s'étend vers le bas et vers l'avant à partir du premier trou traversant.

12. Support de montage (200) selon l'une quelconque des revendications 9-11, dans lequel l'extrémité inférieure (212) de la première partie (210) comprend une poche (234) configurée pour recevoir de manière verrouillée un premier élément de fixation (252) du dispositif de fixation (251, 252), tel qu'un élément de fixation femelle (252) du dispositif de fixation (251, 252).

13. Kit de montage (300) pour fixer le rail de montage (100) selon l'une quelconque des revendications 1-6 sur un poteau (2), dans lequel ledit kit de montage (300) comprend :
- un adaptateur de poteau (310) configuré pour être fixé au rail de montage (100) avec une face avant (313) de l'adaptateur de poteau (310) faisant face au rail de montage (100) et une face arrière (314) de l'adaptateur de poteau (310) faisant face au poteau (2), dans lequel l'adaptateur de poteau (310) est formé de manière à pouvoir reposer de manière stable contre le poteau (2) dans une première orientation et dans une seconde orientation, la seconde orientation étant perpendiculaire à la première orientation,
- un dispositif de fixation (350) pour fixer l'adaptateur de poteau (310) au poteau (2) dans au moins une des première et deuxième orientations.

14. Kit de montage (300) selon la revendication 13, dans lequel l'adaptateur de poteau (310) est formé pour définir un premier évidement (315) s'étendant dans une première direction (D1) et un deuxième évidement (316) s'étendant dans une deuxième direction (D2) perpendiculaire à la première direction (D1), dans lequel les deux évidements (315, 316) sont formés dans la face arrière (314) de l'adaptateur de poteau (310) et sont configurés pour recevoir au moins une partie du poteau (2).

15. Système de montage (400) comprenant le rail de montage (100) selon l'une quelconque des revendications 1-6 et le support de montage (200) selon l'une quelconque des revendications 7-12, dans lequel le support de montage (200) est configuré pour être fixé dans la première orientation à la première interface de montage du support du rail de montage (100), et dans lequel le support de montage (200) est configuré pour être fixé dans la deuxième orientation à la deuxième interface de montage du support du rail de montage (100).

16. Système de montage (400) selon la revendication 15, comprenant en outre le kit de montage (300) selon l'une quelconque des revendications 13-14.
